# EUROPÄISCHE PATENTSCHRIFT

(11) **EP 2 012 367 B1**
(45) Veröffentlichungstag und Bekanntmachung des Hinweises auf die Patenterteilung: **29.02.2012**
(21) Anmeldenummer: 07012920.0
(22) Anmeldetag: 02.07.2007
(51) Int. Cl.: H01L 31/072, H01L 21/20, H01L 21/265

(54) **Mehrfachsolarzelle**
Multi solar cell
Cellule solaire multiple

(43) Veröffentlichungstag der Anmeldung: 07.01.2009
(73) Patentinhaber: Fraunhofer-Gesellschaft zur Förderung der angewandten Forschung e.V., 80686 München (DE)
(72) Erfinder: Dimroth, Frank, Dr., 79115 Freiburg (DE); Schöne, Jan, Dipl.-Ing., 79104 Freiburg (DE)
(74) Vertreter: Pfenning, Meinig & Partner GbR

(56) Entgegenhaltungen:
- WO-A-03/052836
- FR-A- 2 774 511
- JP-A- 3 235 371
- US-A- 5 141 894
- US-A1- 2002 185 686
- US-B1- 6 211 095
- US-B1- 6 464 780
- HOLLÄNDER B ET AL: "Substrate engineering by hydrogen or helium implantation for epitaxial growth of lattice mismatched Si1-xGex films on silicon" 17. September 2000 (2000-09-17), ION IMPLANTATION TECHNOLOGY, 2000. CONFERENCE ON SEP. 17-22, 2000, PISCATAWAY, NJ, USA,IEEE, PAGE(S) 326-329 , XP010543075 ISBN: 0-7803-6462-7 * das ganze Dokument *

## Beschreibung

Die Erfindung betrifft eine Mehrfachsolarzelle mit mindestens zwei auf einem Si-Substrat aufgebrachten Schichtstrukturen aus Halbleitern, die pn-Übergänge bilden. Die Mehrfachsolarzelle nach der Erfindung zeichnet sich insbesondere dadurch aus, dass innerhalb des Si-Substrats eine Defektstruktur vorhanden ist. Die Defektstruktur wird durch eine Ionenimplantation vor der Abscheidung der Schichtstruktur für die Mehrfachsolarzelle erzeugt. Die Defektstruktur nimmt dabei Spannungen aufgrund der unterschiedlichen thermischen Ausdehnungskoeffizienten des Si-Substrates und der Halbleitermaterialien auf. Weiterhin können in der Defektstruktur Spannungen aufgrund von Unterschieden in der Gitterkonstante des Si-Substrates und der Halbleitermaterialien abgebaut werden. Die Erfindung betrifft weiterhin ein Verfahren zur Herstellung dieser Mehrfachsolarzelle.

Heute werden Mehrfachsolarzellen aus III-V-Verbindungshalbleitern typischerweise auf Germanium Substrat abgeschieden. Die bekannteste Materialkombination besteht aus drei pn-Übergängen aus GaInP, GaInAs und Germanium. Die verschiedenen Materialien in dieser Solarzellenstruktur können alle mit etwa der gleichen Gitterkonstante auf dem Germaniumsubstrat aufgewachsen werden. Auch die Unterschiede in den thermischen Ausdehnungskoeffizienten zwischen den verschiedenen Materialien sind vernachlässigbar. Solche III-V-Mehrfachsolarzellen auf Germanium erzielen heute die höchsten Wirkungsgrade für die photovoltaische Energiekonversion von bis zu 40 % unter konzentriertem Sonnenlicht. Wesentlich für den Erfolg dieser Solarzellentechnologie sind dabei die hervorragenden Kristallqualitäten mit hohen Diffusionslängen für die Minoritätsladungsträger, die in den III-V-Verbindungshalbleitern erreicht werden. Defekte in den Solarzellenstrukturen wirken als Rekombinationszentren und verringern den Wirkungsgrad. Die Anwendung der III-V-Mehrfachsolarzellen liegt heute zum einen im Weltraum, zum anderen in terrestrischen PV-Konzentratorsystemen.

Das Wachstum von III-V-Verbindungshalbleitern beziehungsweise Germanium auf Silicium wurde eingehend untersucht. Die wesentlichen Probleme beim Wachstum von III-V-Verbindungshalbleitern beziehungsweise Germanium auf Silicium liegen im großen Unterschied der thermischen Ausdehnungskoeffizienten beider Materialien. Hierdurch kommt es beim Abkühlen der Struktur nach der Epitaxie häufig zur Rissbildung in den epitaktischen Schichten. Die Rissbildung in GaAs auf Silicium, beziehungsweise auf SiGe-Pufferschichten wird in Yang, V.K., et al., "Crackformation in GaAs heteroepitaxialfilms on Si and SiGe virtual substrates", Journal of Applied Physics, 2003, 93 (7): p. 3859-65 sehr ausführlich beschrieben. Risse werden bei den typischen Wachstumsbedingungen ab Schichtdicken grö-βer 2 µm beobachtet, wie sie für Solarzellen notwendig sind, um eine ausreichende Absorption des Sonnenlichts zu gewährleisten.

Weiterhin wird in Lee, M.L., D.A. Antoniadis, und E.A. Fitzgerald, "Challenges in epitaxial growth of SiGe buffers on Si (111), (110), and (112)", Thin Solid Films, 2006, 508 (1-2): p. 136-9, das Wachstum von III-V-Mehrfachsolarzellen auf der Basis von Galliumarsenid auf Siliciumsubstrat mit einer SiGe Pufferschicht beschrieben. Die Versetzungsdichten in diesen Strukturen sind noch relativ hoch und die Qualität der Solarzellen dadurch begrenzt. Die Wirkungsgrade liegen bei bis zu 17 % unter AMO Bedingungen. Die Unterschiede in den thermischen Ausdehnungskoeffizienten können in dieser Struktur nicht vollständig aufgefangen werden. In Wut, D.M., et al. "Thermal cycle testing of GaAs on Si and metamorphic tandem on Si solar cells" in Proceedings of the 31st IEEE Photovoltaic Specialists Conference, 2005, Orlando, Florida, USA wurde gezeigt, dass thermische Zyklen im Bereich von -80 bis +80 °C die Rissbildung in den Schichten verstärken können.

Auch in Itoh, Y., et al., "14.5% conversion efficiency GaAs solar cell fabricated on Si substrates", Applied Physics Letters, 1986, 49 (23): p. 1614-16 wird das Wachstum einer GaAs-Solarzelle auf Silicium beschrieben. Es wurde dabei ein Umwandlungswirkungsgrad von 14,5 % erzielt. Die Solarzellenstrukturen zeigen deutliche Rissbildung, welche durch die Unterschiede in den thermischen Ausdehnungskoeffizienten entsteht. In Soga, T., et al. "Improvement of AlGaAs solar cell grown on Si substrate" in Proceedings of the 1st World Conference on Photovoltaic Energy Conversion, 1994, Waikoloa, Hawaii, USA wird eine Al_{0.1}Ga_{0.9}As-Solarzelle auf Silicium gezeigt. Hierbei wurde ein spezielles Verfahren entwickelt, um die Spannungen zwischen den verschiedenen Materialien zu reduzieren. Es wurde eine Galliumantimonid Zwischenschicht eingeführt, die nachträglich über einen Laserpuls lokal relaxiert wird. Die Wirkungsgrade der besten Zellen liegen bei 12,9 %.

Eine Tandemsolarzelle aus AlGaAs/Si mit einem Wirkungsgrad von 20 bis 21,4 % wird in Soga, T., et al., "MOCVD growth of high efficiency current-matched AlGaAs/Si tandem solar cell", Tenth American Conference on Crystal Growth and the Ninth International Conference on Vapor Growth and Epitaxy, 1997, 174 (1-4): p. 579-84 gezeigt. Die Materialqualität wurde durch thermische Zyklen nach dem Wachstum verbessert, wodurch eine gewisse Reduktion der Spannungen in der Solarzellenstruktur erreicht werden kann. Die Wirkungsgrade bleiben aber hinter den theoretischen Erwartungen zurück.

Weiterhin ist aus Schoene, J. et al. "III-V solar cell growth on wafer-bonded GaAs/Si-substrates" in Proceedings of the 4th World Conference on Photovoltaic Energy Conversion, 2006, Waikoloa, Hawaii, USA bekannt, wie Galliumarsenid Solarzellen auf Silicium durch einen Wafer Bonding Prozess hergestellt werden können. Die Wirkungsgrade lagen bei 12 % und auch bei diesen Versuchen wurden zahlreiche Risse in den Epitaxieschichten festgestellt.

Eine gitterangepasste Tandem Solarzellenstruktur wird in Geisz, J.F., M. Olson, and D.J. Friedman, "Toward A monolithic Lattice-Matched III-V on Silicon Tandem Solar Gell" in Proceedings of the 19th European Photovoltaic Solar Energy Conference, 2004, Paris, France beschrieben. Die Struktur besteht aus GaNPAs, welches mit derselben Gitterkonstante wie Silicium hergestellt werden kann. Die Probleme mit den unterschiedlichen thermischen Ausdehnungskoeffizienten der Materialien sind damit aber nicht gelöst.

Ausgehend hiervon ist es deshalb Aufgabe der vorliegenden Erfindung, eine Mehrfachsolarzelle vorzuschlagen, bei der insbesondere die Spannungen aufgrund der unterschiedlichen thermischen Ausdehnungskoeffizienten des Substratmaterials Silizium und Germanium bzw. den III-V-Halbleitern in einem unkritischen Bereich der Struktur abgebaut werden. Weiterhin ist es Aufgabe der vorliegenden Erfindung, dass bei der neuen Solarzelle die Spannungen aufgrund der Unterschiede in den Gitterkonstanten von Si und Germanium bzw. III-V-Halbleiterverbindungen möglichst abgebaut werden. Aufgabe der vorliegenden Erfindung ist es weiterhin, ein entsprechendes Verfahren zur Herstellung solcher Mehrfachsolarzellen vorzuschlagen.

Erfindungsgemäß ist nun die Mehrfachsolarzelle so aufgebaut, dass innerhalb des Si-Substrats, im Bereich der der Schichtstruktur aus dem Halbleiter zugewandten Seite, eine Defektstruktur vorhanden ist. Durch diese erfindungsgemäße Maßnahme wird erreicht, dass die Spannungen aufgrund der unterschiedlichen thermischen Ausdehnungskoeffizienten des Substratmaterials Silizium und der halbleitenden Schichten durch die Defektstruktur abgebaut wird. Gleichzeitig hat es sich gezeigt, dass derartige Solarzellen auch in der Lage sind, die Spannungen aufgrund von Unterschieden in den Gitterkonstanten von Silizium und Germanium bzw. III-V-Halbleiterverbindungen aufzunehmen.

Bei der erfindungsgemäßen Mehrfachsolarzelle führt die Defektstruktur dazu, dass die Diamant-Kristallstruktur von Silicium auf wenigstens 5 % (bevorzugt > 20 %) der Fläche gestört ist.

Bei der erfindungsgemäßen Mehrfachsolarzelle ist es vorteilhaft, wenn die Defektstruktur in Form einer amorphen Schicht vorliegt. Die amorphe Schicht wird dabei durch Ionenimplantieren erzeugt. Geeignete Ionen sind hierbei z.B. Wasserstoff, Helium, Beryllium, Argon, Kohlenstoff, Silicium oder Germanium, wobei als besonders bevorzugte Ionen Wasserstoff und Helium zu nennen sind.

Die amorphe Schicht nach der Erfindung weist dabei günstigerweise einen Abstand von 50 nm bis 2 µm von der Grenzfläche zwischen dem Si-Substrat und der Schichtstruktur aus dem Halbleiter auf. Die amorphe Schicht kann dabei eine Dicke von 50 nm bis 2 µm besitzen.

Von der stofflichen Seite umfassen die III-V-Halbleiter jede Kombination von Al, Ga, In mit P, As, Sb und N, bevorzugte Kombinationen sind GaInP, GaInAs, AlGaAs, AlGaInP, GaInNAs, AlGaInAs, GaInAsP, GaPN, GaInAsPN. Die Anteile der einzelnen Elemente können dabei variieren. So kann z.B. der Aluminiumanteil beim III-V-Halbleiter AlₓGa₁₋ₓAs zwischen 0 und 100 % variieren, wobei dann für x < 0,4 eine indirekte Bandlücke vorliegt, ansonsten besteht eine direkte Bandlücke. Es ist weiter bevorzugt, im Falle von N, dass der N-Gehalt bis zu 10 % beträgt. Weitere geeignete Materialien sind Ge und/oder SiₓGe₁₋ₓ. Der Si-Gehalt kann ebenfalls variieren.

Als Substratmaterial wird gemäß der vorliegenden Erfindung Silizium eingesetzt. Die Verwendung des Siliziums als Substratmaterial bei der vorliegenden Mehrfachsolarzelle nach der Erfindung besitzt mehrere Vorteile.

Die heutigen III-V-Mehrfachsolarzellen werden nämlich überwiegend auf Germanium Substrat abgeschieden. Germanium ist eines der seltensten Elemente in der Erdkruste und kommt nur in stark verdünnter Form vor. Die Photovoltaik auf der anderen Seite ist eine regenerative Energieform mit einem immensen Potenzial. Sollen photovoltaische Konzentratorsystemen dabei in Zukunft einen signifikanten Anteil an der regenerativen Energieerzeugung haben, so wird die Verfügbarkeit von Germanium schon bald den weiteren Ausbau dieser Technologie hemmen. Es wird erwartet, dass die Verfügbarkeit von Germanium die maximale jährliche Produktion auf 20 GW/Jahr an photovoltaischen Konzentratorsystemen begrenzt. Aus diesem Grund ist es entscheidend, langfristig ein Substratmaterial mit einer höheren Verfügbarkeit zu entwickeln. Ein möglicher Kandidat ist das Silicium.

Silicium hat als Substrat neben der hohen Verfügbarkeit weitere Vorteile: Silicium Substrate sind etwa um einen Faktor zehn günstiger als Germanium. Silicium besitzt eine höhere Bruchfestigkeit und es können daher dünnere Substrate verarbeitet werden. Auch die thermische Leitfähigkeit von Silicium ist besser als diejenige von Galliumarsenid oder Germanium, was Vorteile für die Anwendung in Konzentratorsystemen hat. Das spezifische Gewicht von Silicium ist geringer als das von Germanium oder Galliumarsenid, was einen Vorteil für die Anwendung der Solarzellen im Weltraum mit sich bringt. Desweiteren sind schon heute Silicium Substrate mit einem Durchmesser von bis zu 300 mm mit hervorragender Kristallqualität erhältlich. Und schließlich gibt es aus der Mikroelektronik eine große Erfahrung hinsichtlich der Prozessführung von Halbleiterbauelementen auf Silicium. Hierzu gehört auch, dass Maschinen mit hohem Durchsatz auf großen Flächen verfügbar sind, so wie sie auch für eine großflächige Anwendung in der Photovoltaik notwendig sind.

Die erfindungsgemäße Mehrfachsolarzelle besitzt weiterhin, wie aus dem Stand der Technik bekannt, Rückseiten- und Frontkontakte. In Bezug auf die Kontaktierung betreffend die Dimensionierung und Materialwahl wird auf den einschlägigen Stand der Technik, z.B. F. Dimroth et al, "Metamorphic GaInP/GaInAs Tandem Solar Cells for Space and for Terrestrial Concentrator Applications at C>1000 Suns", Prog. Photovolt: Res. Appl. 2001; 9:165-178, verwiesen.

Die erfindungsgemäße Solarzelle, wie vorstehend beschrieben, weist nun mehrere Vorteile auf. Zum einen hat es sich gezeigt, dass durch das Si-Substrat mit der Defektstruktur Spannungen zwischen den Halbleitern und dem Siliziumsubstrat weitgehend vermieden werden, da offensichtlich die Spannung aufgrund der unterschiedlichen thermischen Ausdehnungskoeffizienten von Silizium und Germanium bzw. den III-V-Halbleitern durch die Defektstruktur aufgenommen wird. Weiterhin können in der Defektstruktur Spannungen aufgrund von Unterschieden in den Gitterkonstanten von Silizium und Germanium bzw. den III-V-Halbleitern abgebaut werden. Dies führt im Endeffekt dazu, dass die Schichten der erfindungsgemäßen Solarzelle im Wesentlichen rissfrei sind und dass die Versetzungsdichten in den Emitter- und Basisschichten der Teilzellen kleiner als 10⁶ cm⁻² sind.

Die Erfindung betrifft weiterhin ein Verfahren zur Herstellung der vorstehend beschriebenen Mehrfachsolarzelle. Bevorzugt wird beim erfindungsgemäßen Verfahren dabei so vorgegangen, dass die Defektstruktur in Form der amorphen Schicht durch Ionenimplantation hergestellt wird.

Erfindungsgemäß werden dazu zunächst hochenergetische Wasserstoffionen gleichmäßig in ein Siliciumsubstrat implantiert. Weitere mögliche Ionen sind zum Beispiel: He, Be, Ar, C, Si oder Ge. Die Energie der Ionen wird so gewählt, dass sich nahe der Oberfläche des Siliciumsubstrats (typisch 0,1 - 2 µm) eine Defektschicht ausbildet. Bevorzugt ist diese als amorphe Schicht ausgebildet. Die Tiefe dieser Schicht, in der die Ionen gestoppt werden, hängt von der Energie und der Masse der Ionen ab. Die Ionen verlieren im Silicium ihre Energie über Coulombwechselwirkung mit den Elektronen der Kristallatome und über Stöße mit den Atomrümpfen. Der zweite Vorgang beinhaltet Kollisionen mit den Kristallatomen und führt im Wesentlichen zu den atomaren Störstellen durch die Implantation. Die Dosis der implantierten Ionen bestimmt, wie hoch die Defektdichte ist. Typische Implantationsparameter für Wasserstoff liegen im Bereich: Energie: 10 - 150 kV, optimal 20 bis 90 kV, Dosis: 5E15-1E17 cm⁻², optimal 1E16 - 5E16 cm⁻², Ionenstrom: 50 - 100 µA, optimal 60 - 80 µA.

Die Implantationsparameter werden so gewählt, dass sich eine versetzungsreiche Schicht unterhalb der Silicium Oberfläche bildet, aber auf der anderen Seite die Oberfläche möglichst ungestört bleibt und die gestoppten Wasserstoffionen noch nicht zu einer Blasenbildung führen. Es ist bekannt, dass die Implantation von Wasserstoff in Silicium dazu benutzt werden kann, absichtlich Hohlräume in der defektreichen Stoppschicht zu erzeugen. Diese können bei einem späteren Hochtemperaturschritt dazu führen, dass der Kristall an der Stoppschicht aufplatzt und abgespalten wird.

Erfindungsgemäß werden die implantierten Silicium Wafer anschließend als Substrat für das Wachstum einer III-V-Mehrfachsolarzellenstruktur verwendet. Neben III-V Verbindungshalbleitern wie GaInP, GaInAs, AlGaAs, AlGaInP, GaInNAs, GaPN oder GaInAsPN kann die Struktur dabei auch Ge, oder SiGe-Schichten enthalten. Wesentlich ist, dass die Materialien, welche auf das implantierte Siliciumsubstrat gewachsen werden einen anderen thermischen Ausdehnungskoeffizienten besitzen im Vergleich zum Silicium. (Beispiel thermischer Ausdehnungskoeffizient Si = 2,6x10⁻⁶ K⁻¹ und GaAs = 6,8 x10⁻⁶ K⁻¹)

Während des Wachstums der Solarzellenstruktur auf dem implantierten Siliciumsubstrat können sich bereits Versetzungen im Bereich der implantierten Schicht bilden und somit Spannung reduzieren, die zum Beispiel durch eine Gitterfehlanpassung der Materialien entstehen. Von besonderer Bedeutung ist aber, dass die implantierte Schicht die Spannungen aufnimmt, welche beim Abkühlen der Struktur entstehen und somit verhindert, dass sich Risse bilden.

Die Erfindung wird nachfolgend anhand von drei beispielhaften Ausführungsformen näher beschrieben.
- Figur 1: zeigt den schematischen Aufbau einer Mehrfachsolarzellenstruktur nach der Erfindung,
- Figur 2: eine Mehrfachsolarzelle mit drei Halbleiterschichtstrukturen und
- Figur 3: eine Mehrfachsolarzelle mit zwei Halbleiterschichtstrukturen.

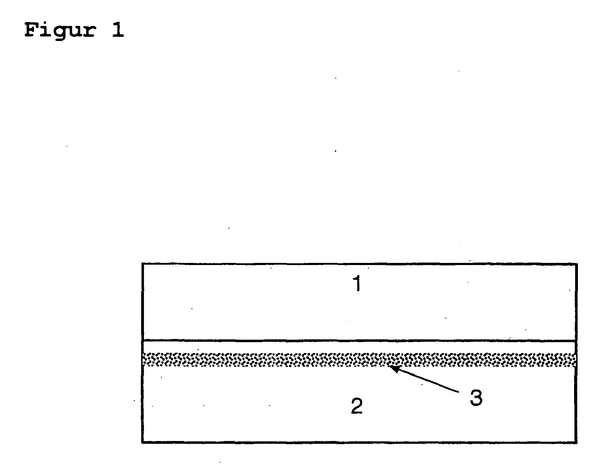

In Figur 1 ist schematisch im Schnitt eine III-V-Mehrfachsolarzellenstruktur 1 dargestellt. Diese III-V-Mehrfachsolarzellenstruktur kann aus verschiedenen III-V-Halbleiterschichten und/oder Ge bzw. SiGe mit einer Dicke von 1 bis 10 µm bestehen. Das Siliziumsubstrat ist in Figur 1 mit 2 bezeichnet und die defektreiche Schicht, die als amorphe Schicht 3 vorliegt, ist durch Ionenimplantation gebildet worden. Das Substrat 2 weist bevorzugt eine Dicke von 100 bis 600 µm und die defektreiche Schicht 3 eine Dicke von 10 nm bis 1 µm auf. Der Abstand der Schicht 3 zur Grenzfläche der Struktur 1 beträgt 10 nm bis 1 µm.

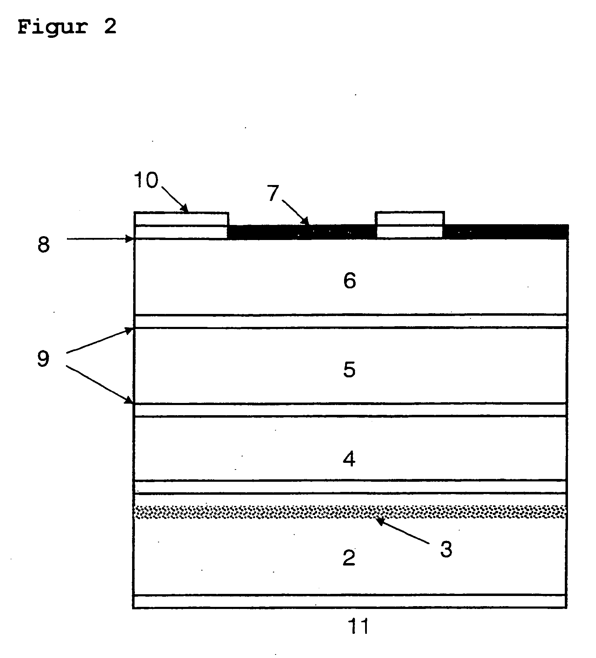

In Figur 2 ist eine Solarzelle dargestellt, die aus GaInP (6), GaInAs (5) und Ge (4) Teilzellen besteht, die auf dem Silicium Substrat (2) mit der implantierten Schicht (3) aufgewachsen sind. Die verschiedenen Teilzellen sind durch Tunneldioden (9) seriell miteinander verschaltet. Auf der Vorderseite der Zelle befindet sich unter den Kontakten (10) eine hoch dotierte Cap-Schicht (8). Zwischen den Kontaktfingern eine dielektrische Antireflexschicht (7) zur Reduktion von Reflexionsverlusten. Schließlich der Rückseitenkontakt (11).

Alternativ könnten auch andere Materialien für die Teilzellen der Mehrfachsolarzelle verwendet werden. Zum Beispiel AlGaInP (6), AlGaInAs (5) und GalnNAs (4). Bei all diesen Strukturen sind die Schichten der Mehrfachsolarzelle nicht gitterangepasst zum Silicium Substrat.

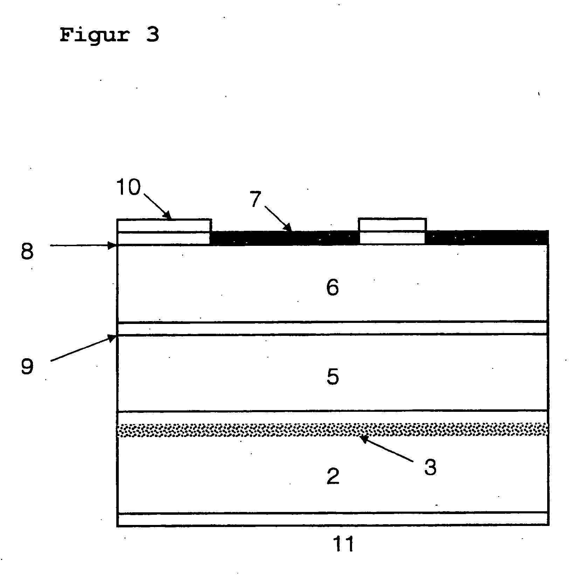

Die Solarzelle nach der Erfindung kann auch aus nur zwei Teilzellen bestehen. Ein mögliches Beispiel ist in Figur 3 gezeigt und besteht zum Beispiel aus einer GaInNAsP-Oberzelle (6) und einer weiteren GaInNAsP-Zelle (5) mit einer geringeren Bandlückenenergie. Diese komplette Struktur kann mit der Gitterkonstante von Silicium gewachsen werden. Alternativ ist die obere Teilzelle aus GaInP (6) und die untere Teilzelle aus GaAs (5). In diesem Fall ist die Mehrfachsolarzellenstruktur nicht gitterangepasst zum Silicium Substrat.

## Patentansprüche

1. Mehrfachsolarzelle mit mindestens zwei, auf einem Si-Substrat (2) übereinander aufgebrachten Schichtstrukturen (1) aus III-V-Halbleitern und/oder Ge und/oder SiₓGe₁₋ₓ, die pn-Übergänge bilden, sowie Rückseiten- und Frontkontakten, **dadurch gekennzeichnet, dass** innerhalb des Si-Substrates (2) im Bereich der der Schichtstruktur (1) aus dem Halbleiter zugewandten Seite, eine Defektstruktur (3) vorhanden ist.

2. Mehrfachsolarzelle nach Anspruch 1, **dadurch gekennzeichnet, dass** die Defektstruktur (3) zu einer Störung der Diamant-Kristallstruktur von Silicium auf wenigstens 5 %, bevorzugt 20 % der Fläche führt.

3. Mehrfachsolarzelle nach Anspruch 1 oder 2, **dadurch gekennzeichnet, dass** die Defektstruktur (3) eine amorphe Si-Schicht ist.

4. Mehrfachsolarzelle nach Anspruch 3, **dadurch gekennzeichnet, dass** die amorphe Schicht einen Abstand von 50 nm bis 2 µm von der Grenzfläche zwischen dem Si-Substrat und der Schichtstruktur aus dem Halbleiter aufweist.

5. Mehrfachsolarzelle nach mindestens einem der Ansprüche 3 oder 4, **dadurch gekennzeichnet, dass** die amorphe Schicht durch Implantieren von Ionen gebildet worden ist.

6. Mehrfachsolarzelle nach Anspruch 5, **dadurch gekennzeichnet, dass** die Konzentration der Ionen in der Defektstruktur (3) > 10¹⁷ cm³ ist.

7. Mehrfachsolarzelle nach Anspruch 5 oder 6, **dadurch gekennzeichnet, dass** die Ionen ausgewählt sind aus H, He, Be, Ar, C, Si oder Ge.

8. Mehrfachsolarzelle nach mindestens einem der Ansprüche 3 bis 7, **dadurch gekennzeichnet, dass** die amorphe Schicht eine Schichtdicke von 10 nm bis 1 µm aufweist.

9. Mehrfachsolarzelle nach mindestens einem der Ansprüche 1 bis 8, **dadurch gekennzeichnet, dass** die III-V-Halbleiter ausgewählt sind aus GaInP, GaInAs, AlGaAs, AlGaInP, GaInNAs, GaPN, GaInAsPN, AlGaInAs und GaInAsP.

10. Mehrfachsolarzelle nach mindestens einem der Ansprüche 1 bis 9, **dadurch gekennzeichnet, dass** die Gitterkonstanten der III-V-Halbleiter nicht mehr als 0,1 % von der Gitterkonstante des Si-Substrates abweichen.

11. Mehrfachsolarzelle nach mindestens einem der Ansprüche 1 bis 10, **dadurch gekennzeichnet, dass** die Versetzungsdichten in den Emitter und Basisschichten der Teilzellen kleiner als 10⁶ cm⁻² sind.

12. Mehrfachsolarzelle nach mindestens einem der Ansprüche 1 bis 11, **dadurch gekennzeichnet, dass** die Halbleiterschichten im Wesentlichen rissfrei sind.

13. Mehrfachsolarzelle nach mindestens einem der Ansprüche 1 bis 12, **dadurch gekennzeichnet, dass** die mindestens zwei Schichtstrukturen aus dem Halbleiter über Tunneldioden seriell miteinander verschaltet sind.

14. Mehrfachsolarzelle nach Anspruch 13, **dadurch gekennzeichnet, dass** die pn-Übergänge durch GaInP, GaInAs und/oder GaAsP gebildet sind.

15. Verfahren zur Herstellung einer Mehrfachsolarzelle nach mindestens einem der Ansprüche 1 bis 14, **dadurch gekennzeichnet, dass** in einem ersten Schritt eine Defektstruktur (3) in Silizium erzeugt und anschließend die weiteren Schichten aus dem Halbleiter zur Bildung der Solarzelle abgeschieden werden.

16. Verfahren nach Anspruch 15, **dadurch gekennzeichnet, dass** die Defektstruktur (3) in Form der amorphen Schicht durch Ionenimplantation hergestellt wird.

17. Verfahren nach Anspruch 16, **dadurch gekennzeichnet, dass** die Energie der Ionen so gewählt wird, dass sie im Bereich zwischen 10 bis 150 kV, bevorzugt zwischen 20 bis 90 kV liegt.

18. Verfahren nach Anspruch 16 oder 17, **dadurch gekennzeichnet, dass** die Dosis der Ionen so gewählt wird, dass sie im Bereich von 1*10¹⁵ bis 1*10¹⁷ cm⁻², bevorzugt 1*10¹⁶ bis 5*10¹⁶ cm⁻² liegt.

19. Verfahren nach mindestens einem der Ansprüche 16 bis 18, **dadurch gekennzeichnet, dass** der Ionenstrom so gewählt wird, dass er im Bereich von 50 bis 100 µA, bevorzugt 60 bis 80 µA liegt.

20. Verfahren nach mindestens einem der Ansprüche 16 bis 19, **dadurch gekennzeichnet, dass** die Ionen in Kristallrichtung implantiert werden.

21. Verfahren nach mindestens einem der Ansprüche 16 bis 20, **dadurch gekennzeichnet, dass** die Tiefe der amorphen Schicht durch die Energie, Dosis und/oder den Ionenstrom gesteuert wird.

22. Verfahren nach mindestens einem der Ansprüche 15 bis 21, **dadurch gekennzeichnet, dass** die Schichten aus den Halbleitern mittels metallorganischer Gasphasenepitaxie auf dem Siliziumsubstrat abgeschieden werden.

23. Verfahren nach mindestens einem der Ansprüche 15 bis 22, **dadurch gekennzeichnet, dass** die Si-Substrate während der Implantation geheizt werden.

## Claims

1. Multiple solar cell having at least two layer structures (1), which are applied one above the other on an Si substrate (2), are made of III-V semiconductors and/or Ge and/or SiₓGe₁₋ₓ and form p-n junctions, and also rear-side- and front contacts,
***characterised in that***
a defect structure (3) is present inside the Si substrate (2) in the region of the layer structure (1) on the side orientated towards the semiconductor.

2. Multiple solar cell according to claim 1, **characterised in that** the defect structure (3) leads to a disruption in the diamond crystal structure of silicon to at least 5%, preferably 20%, of the area.

3. Multiple solar cell according to claim 1 or 2, **characterised in that** the defect structure (3) is an amorphous Si layer.

4. Multiple solar cell according to claim 3, **characterised in that** the amorphous layer has a spacing of 50 nm to 2 µm from the interface between the Si substrate and the layer structure made of the semiconductor.

5. Multiple solar cell according to at least one of the claims 3 or 4, **characterised in that** the amorphous layer was formed by implanting ions.

6. Multiple solar cell according to claim 5, **characterised in that** the concentration of ions in the defect structure (3) is > 10¹⁷ cm³.

7. Multiple solar cell according to claim 5 or 6, **characterised in that** the ions are selected from H, He, Be, Ar, C, Si or Ge.

8. Multiple solar cell according to at least one of the claims 3 to 7, **characterised in that** the amorphous layer has a layer thickness of 10 nm to 1 µm.

9. Multiple solar cell according to at least one of the claims 1 to 8, **characterised in that** the III-V semiconductors are selected from GaInP, GaInAs, AlGaAs, AlGaInP, GaInNAs, GaPN, GaInAsPN, AlGaInAs and GaInAsP.

10. Multiple solar cell according to at least one of the claims 1 to 9, **characterised in that** the lattice constants of the III-V semiconductors deviate by no more than 0.1% from the lattice constant of the Si substrate.

11. Multiple solar cell according to at least one of the claims 1 to 10, **characterised in that** the dislocation densities in the emitter and base layers of the partial cells are less than 10⁶ cm⁻².

12. Multiple solar cell according to at least one of the claims 1 to 11, **characterised in that** the semiconductor layers are essentially crack-free.

13. Multiple solar cell according to at least one of the claims 1 to 12, **characterised in that** the at least two layer structures made of the semiconductor are connected to each other in series via tunnel diodes.

14. Multiple solar cell according to claim 13, **characterised in that** the p-n junctions are formed by GaInP, GaInAs and/or GaAsP.

15. Method for manufacturing a multiple solar cell according to at least one of the claims 1 to 14, **characterised in that**, in a first step, a defect structure (3) is produced in silicon and subsequently the further layers made of the semiconductor are deposited to form the solar cell.

16. Method according to claim 15, **characterised in that** the defect structure (3) is produced in the form of the amorphous layer by ion implantation.

17. Method according to claim 16, **characterised in that** the energy of the ions is chosen such that it is in the range between 10 to 150 kV, preferably between 20 to 90 kV.

18. Method according to claim 16 or 17, **characterised in that** the metered quantity of ions is chosen such that it is in the range of 1*10¹⁵ to 1*10¹⁷ cm⁻², preferably 1*10¹⁶ to 5*10¹⁶ cm⁻².

19. Method according to at least one of the claims 16 to 18, **characterised that** the ion current is chosen such that it is in the range of 50 to 100 µA, preferably 60 to 80 µA.

20. Method according to at least one of the claims 16 to 19, **characterised that** the ions are implanted in the crystal direction.

21. Method according to at least one of the claims 16 to 20, **characterised that** the depth of the amorphous layer is controlled by the energy, metered quantity and/or the ion current.

22. Method according to at least one of the claims 15 to 21, **characterised that** the layers made of the semiconductors are deposited on the silicon substrate by means of metalorganic vapour-phase epitaxy.

23. Method according to at least one of the claims 15 to 22, **characterised in that** the Si substrates are heated during implantation.

## Revendications

1. Cellule solaire multi-jonction avec au moins deux structures stratifiées (1) appliquées l'une sur l'autre sur un substrat de Si (2), constituées de semi-conducteurs III-V et/ou de Ge et/ou de SiₓGe₁₋ₓ, qui forment des jonctions PN, ainsi que des contacts arrière et avant,
**caractérisée en ce qu'**une structure défectueuse (3) est présente dans le substrat de Si (2) dans la zone du côté tourné vers la structure stratifiée (1) formée du semi-conducteur.

2. Cellule solaire multi-jonction selon la revendication 1, **caractérisée en ce que** la structure défectueuse (3) conduit à une perturbation de la structure cristalline de type diamant du silicium à hauteur d'au moins 5 %, de préférence 20 % de la surface.

3. Cellule solaire multi-jonction selon la revendication 1 ou 2, **caractérisée en ce que** la structure défectueuse (3) est une couche de Si amorphe.

4. Cellule solaire multi-jonction selon la revendication 3, **caractérisée en ce que** la couche amorphe présente une distance de 50 nm à 2 µm de la surface limite entre le substrat de Si et la structure stratifiée formée du semi-conducteur.

5. Cellule solaire multi-jonction selon au moins l'une quelconque des revendications 3 ou 4, **caractérisée en ce que** la couche amorphe a été formée par implantation d'ions.

6. Cellule solaire multi-jonction selon la revendication 5, **caractérisée en ce que** la concentration en ions dans la structure défectueuse (3) est > 10¹⁷ cm³.

7. Cellule solaire multi-jonction selon la revendication 5 ou 6, **caractérisée en ce que** les ions sont choisis parmi les éléments H, He, Be, Ar, C, Si ou Ge.

8. Cellule solaire multi-jonction selon au moins l'une quelconque des revendications 3 à 7, **caractérisée en ce que** la couche amorphe présente une épaisseur de couche de 10 nm à 1 µm.

9. Cellule solaire multi-jonction selon au moins l'une quelconque des revendications 1 à 8, **caractérisée en ce que** les semi-conducteurs III-V sont choisis parmi les composés GaInP, GaInAs, AlGaAs, AlGaInP, GaInNAs, GaPN, GaInAsPN, AlGaInAs et GaInAsP.

10. Cellule solaire multi-jonction selon au moins l'une quelconque des revendications 1 à 9, **caractérisée en ce que** les constantes de réseau des semi-conducteurs III-V ne divergent pas de plus de 0,1 % de la constante de réseau du substrat de Si.

11. Cellule solaire multi-jonction selon au moins l'une quelconque des revendications 1 à 10, **caractérisée en ce que** les densités de dislocations dans les émetteurs et les couches de base des cellules partielles sont inférieures à 10⁶ cm⁻².

12. Cellule solaire multi-jonction selon au moins l'une quelconque des revendications 1 à 11, **caractérisée en ce que** les couches semi-conductrices sont sensiblement exemptes de fissures.

13. Cellule solaire multi-jonction selon au moins l'une quelconque des revendications 1 à 12, **caractérisée en ce que** les au moins deux structures stratifiées formées du semi-conducteur sont connectées les unes aux autres en série via des diodes tunnels.

14. Cellule solaire multi-jonction selon la revendication 13, **caractérisée en ce que** les jonctions PN sont formées par les composés GaInP, GaInAs et/ou GaAsP.

15. Procédé de fabrication d'une cellule solaire multi-jonction selon au moins l'une quelconque des revendications 1 à 14, **caractérisée en ce que**, dans une première étape, une structure défectueuse (3) est générée dans du silicium, puis les autres couches formées du semi-conducteur sont déposées pour former la cellule solaire.

16. Procédé selon la revendication 15, **caractérisé en ce que** la structure défectueuse (3) est fabriquée selon la forme de la couche amorphe par implantation ionique.

17. Procédé selon la revendication 16, **caractérisé en ce que** l'énergie des ions est choisie de sorte qu'elle se situe dans la plage comprise entre 10 et 150 kV, de préférence entre 20 et 90 kV.

18. Procédé selon la revendication 16 ou 17, **caractérisé en ce que** la dose des ions est choisie de sorte qu'elle se situe dans la plage de 1*10¹⁵ à 1*10¹⁷ cm⁻², de préférence de 1 *10¹⁶ à 5*10¹⁶ cm⁻².

19. Procédé selon au moins l'une quelconque des revendications 16 à 18, **caractérisé en ce que** le courant ionique est choisi de sorte qu'il se situe dans la plage de 50 à 100 µA, de préférence de 60 à 80 µA.

20. Procédé selon au moins l'une quelconque des revendications 16 à 19, **caractérisé en ce que** les ions sont implantés dans la direction du cristal.

21. Procédé selon au moins l'une quelconque des revendications 16 à 20, **caractérisé en ce que** la profondeur de la couche amorphe est décidée par l'énergie, la dose et/ou le courant ionique.

22. Procédé selon au moins l'une quelconque des revendications 15 à 21, **caractérisé en ce que** les couches formées des semi-conducteurs sont déposées sur le substrat de silicium par épitaxie en phase vapeur aux organométalliques.

23. Procédé selon au moins l'une quelconque des revendications 15 à 22, **caractérisé en ce que** les substrats de Si sont chauffés au cours de l'implantation.
